# EUROPEAN PATENT SPECIFICATION

(11) **EP 0 231 384 B1**
(45) Date of publication and mention of the grant of the patent: **06.10.1993**
(21) Application number: 86904376.0
(22) Date of filing: 14.07.1986
(51) Int. Cl.: B42D 15/02, G06K 19/00, H05K 1/11

(54) **A method for preparing a printed wiring board for installation in an IC card**
Ein Verfahren zum Herstellen einer gedruckten Schaltungsplatte für Halbleiterschaltungen
Procédé de fabrication d'une plaquette à câblage imprimé pour cartes à circuits intégrés

(30) Priority: 17.07.1985 JP 159192/85; 11.11.1985 JP 253324/85
(43) Date of publication of application: 12.08.1987
(73) Proprietor: IBIDEN CO, LTD., Ogaki-shi Gifu 503 (JP)
(72) Inventor: NAKANISHI, Chiaki, Kishiwada-shi Osaka 596 (JP); HIROI, Atsushi, Ogaki-shi Gifu 503 (JP); YANAGAWA, Yoji, Kuwana-shi Mie 511 (JP)
(74) Representative: Sajda, Wolf E., Dipl.-Phys.
(86) International application number: JP8600356
(87) International publication number: WO8700486

(56) References cited:
- GB-A- 1 138 939
- GB-A- 2 081 974
- JP-A- 5 626 451
- JP-A- 5 811 198
- JP-A- 5 827 287
- JP-A-57 188 849
- US-A- 3 838 984
- US-A- 4 417 393

## Description

The invention relates to a method for preparing a printed wiring board for installation in an IC card, wherein the printed wiring board comprises a substrate of a non-conductive material, a printed wiring pattern on the substrate, and external contact terminals on the printed wiring pattern, adapted for operation in a reader/writer of IC cards.

Such cards can be used as bank cards, identification cards, medical examination cards or the like.

Such a printed wiring board for installation in an IC card is provided with external contact terminals required to transmit and receive information from a reader/writer of IC cards in order to get in contact with IC chips mounted on the wiring board, and a conductor circuit electrically connecting such external contact terminals with the corresponding IC chips or the like.

Before explaining method for preparing the printed wiring board for installation in IC cards according to the present invention, there will be explained an IC module wherein IC chips or the like are mounted on a printed wiring board for IC cards and an IC card itself in which the IC module is installed. In consideration of the reliability and convenience of use and the like, this kind of IC card is required to meet the following respective requirements:
(1) The IC card must be properly small and thin as a whole so as to be easily carried, controlled and inserted into the above mentioned reader/writer for IC cards.
   In particular, for this concrete requirement, the thickness of all the IC cards is made about 0,76 mm so as to conform to the size of generally used bank cards and the like. By the way, as the thickness of the IC chips arranged within the IC card is more than 0,25 mm at present, the thickness of an IC module except the external contact terminal is now more than 0,3 mm.
(2) The IC card must electrically and frequently be contacted with a reader/writer for IC cards by the external contact terminals exposed on the surface and therefore these external contact terminals must always be high in their durability and provide a good electric contact in the operation.
(3) The IC card must be small and thin as explained in (1) above. In such a case, the IC card is likely to be bent during the use. Even in case the IC card is thus bent, the conductor circuit for the IC chips built in or fitted to the IC card must not be broken and the IC module provided with the IC chips must not be removed from the IC card.
(4) In the IC card, as described in (2) above, the external contact terminals must be exposed, however, water and dust which may adversely influence the IC chips, must not easily enter the IC card.

The IC card is basically formed of a sheet-shaped card material which is a base material formed of plastics such as vinyl chloride, and an IC module including IC chips and a printed wiring board. Particularly, in the case of a contact type IC card, the external contact terminals for transmitting and receiving electric signals must be exposed on the surface of the IC card as described above. The method of joining the sheet-shaped card material with the IC module for this purpose has progressed step by step and the historical development can be largely divided into three kinds as shown in the study "Trend of Development of the Multifunctional Card System and New Application Field" provided by Japan Industrial Technical Center on March 13 and 14, 1984 and in Figs. 12 to 14 based on the same.

Figs. 12 to 14 show vertical section views of the structures of IC cards joined by respective joining methods. The development steps of IC cards are shown in the order of these views.

Fig. 12 shows a partly magnified vertical sectional view of an IC card wherein a predetermined through hole is formed in a sheet-shaped card material 31 and an IC module 12 is inserted in this through hole. Also, the IC module 12 and the sheet-shaped card material 31 are joined with each other only with their side walls. Therefore, the IC card shown in Fig. 12 is likely to be simply removed from the sheet-shaped card material 31. It can satisfy the requirement of (1) above but it cannot satisfy the requirement of (3) above; the thickness of the IC card is less than 1 mm, therefore the joining strength is low and the practical range of use is small.

Fig. 13 shows a partly magnified vertical sectional view of an IC card disclosed, for example, in JP-A-210494/1982. In the IC card shown in this drawing, a recess is formed in the sheet-shaped card material 31 and an IC module 12 is fitted in this recess and is laminated on the underside with an over sheet 32. This IC module 12 is fitted in the recess of the sheet-shaped card material 31 so that its upper surface together with an external contact terminal (to which a conductor circuit 13 itself on the IC module 12 corresponds) formed on it may be exposed on the surface of the card. That is to say, it is disclosed in the above mentioned JP-A-210494/1982 that the IC module 12 is inserted and bonded in a recess formed in the sheet-shaped card material 31 with a blade. However, an IC card of this type has a defect in that, in case the card is bent so as to be convex upward, the IC module 12 will spring out and cannot satisfy the requirement of (3) above.

Fig. 14 shows a partly magnified vertical sectional view of an IC card disclosed, for example, in document JP-A-26541/1981. The IC card shown in this drawing can be called a "laminated type". In this laminated type IC card, over sheets 32 are bonded both on upper and lower surfaces of the IC module 12 and an aperture is formed in the upper side over sheet 32 to expose the conductor circuit 13 to provide an external contact terminal part. It is disclosed in the above mentioned JP-A-26541/1981 that, in the IC card shown in Fig. 14, the over sheet 32 in which only the part corresponding to the external contact terminal is cut off, is bonded on the IC module 12. The IC card shown in JP-A-26541/1981 can satisfy the requirement of (3) above to some extent but is not satisfactory enough for the following reasons according to the researches made by the inventors.

That is to say, in order to prevent the IC module 12 from springing out in case the IC card is bent, in case the over sheet 32 made of the usual material vinyl chloride is used, the thickness of the over sheet 32 must be at least 0,1 mm and, if possible, more than 0,15 mm. This is also supported by the bending standard test in the interim report of "ISO/TC 97/SC 17 Identification and Credit Cards" June, 1984. As the thickness of the over sheet 32 used for this IC card must be more than 0,1 mm, the thickness of the external contact terminal of the IC module 12 coated with this over sheet 32 must be at least 0,1 mm. Unless the external contact terminal is of such thickness, the external contact terminal part will be positioned as retreated from the surface of the IC card by the thickness of the over sheet 32. Therefore, the problem of dust, accumulating in the recess formed thereby, will arise in case the IC card is used often, and the electric contact reliability of the external contact terminals will become very low.

As described above, in order to satisfy the requirements of (1) to (4) above in an IC card, if the trend of this technical field is considered, the amount by which the external contact terminal formed on the IC module 12 projects from the IC module 12 surface need be more than is predetermined (at least 0,1 mm). In other words, in a printed wiring board for IC cards according to the present invention, the amount of the projection of the external contact terminal is required to be at least 0,1 mm.

Also, as described above, the total thickness allowable in this kind of IC card is 0,76 mm. As the thickness of the IC chip is usually more than 0,25 mm, the thickness of the IC module 12 less the external contact terminal is required to be more than 0,3 mm. Therefore, in the IC card of the type laminated with the over sheets 32 on both surfaces, the thickness of the over sheets 32 on the front side and the rear side is less than 0,46 mm. By the way, the over sheets 32 on the front and back may be substantially of the same thickness in order to prevent warping. Therefore, the thickness of the over sheet 32 on the external contact terminal side is less than 0,23 mm. The thickness of the external contact terminal corresponding to it may be also likewise less than 0,23 mm. However, in case the external contact terminal and the conductor circuit 13 are simultaneously formed, in consideration of the fact that the thickness of the conductor circuit 13 which must be laminated with the over sheet 32 so as not to protrude outside is 0,025 to 0,07 mm, the thickness of the external contact terminal must be about 0,3 mm.

Now, in the conventional printed wiring board for IC cards of this kind, no reference is found in the above mentioned respective data and in the data related to the field how to concretely increase the thickness of the external contact terminal, for example, in JP-A-26451/1981.

Also, an identification card is known wherein IC chips for processing electric signals are provided and are fitted to separate supporting members inserted in a window, is disclosed wherein the thickness of the supporting member is made substantially equal to that of the identification card, the IC chips are arranged within the supporting members, the shape of the window is made similar to the shape of the supporting member, the window is made larger than the suporting member so that the supporting member may be enclosed with a gap and the supporting member is supported within the window by a basically elastic coupling member .

In particular, in the prior art technique where such an external contact terminal was formed simultaneously with the other conductor circuit 13 on the surface of the IC module 12, it was very difficult to form an external contact terminal having a predetermined thickness. Therefore, the concrete formation of the external contact terminal of this kind could not be disclosed at that time.

The concrete formation of the external contact terminal formed by a conventional technique as considered on the basis of the conventional technical level known to the inventors is as follows. The conductor circuit 13 and the external contact terminal are formed on the surface of the IC module 12 usually by etching a conductor foil on the IC module 12. That is to say, as shown in Fig. 15, an etching mask 14 is applied to the conductor foil surface on the surface of the IC module 12 and the range shown by the two-point chain lines is maintained due to this etching mask 14. However, in such a case, it is very difficult to etch this conductor foil along lines at right angles with the etching mask 14. Usually, the result is as shown in Fig. 16. That is to say, the side wall of the conductor circuit 13 or external contact terminal formed by etching is not etched straight at right angles but is curved as shown in Fig. 16 by the impregnation with the etching liquid. With such a shape, the side wall of the conductor curcuit 13 or external contact terminal will be deformed and, in case the external contact terminal is to be laminated with an over sheet 32 so as to expose the surface, the side end part of the over sheet 32 will ride on a part of the side of the external contact terminal and, as shown in Fig. 16, the external contact terminal will not be able to be efficiently laminated with the over sheet 32 so as to be flush with the surface of the external contact terminal.

This will be described more concretely. In the case of etching such a metal as a copper foil, the etching factor will be about 2. Therefore, the sides of the external contact terminal will not be at right angles but will have a slope at an angle of about 60 degrees. Further, in the case of a metal being 0,1 to 0,3 mm thick, the width of the part of this slope will reach 0,05 to 0,15 mm. Therefore, as shown in Fig. 16, in the case of laminating the IC module 12 with the over sheet 32, a gap will be created between the sides of the external contact terminal, the over sheet 32 will overlap on the above mentioned slope and the surface of the over sheet 32 will not be flush with the surface of the external contact terminal. Thus, an acceptable lamination with the over sheet 32 was in fact impossible to obtain.

A method for preparing a printed wiring board for installation in an IC card is known from EP-A-0 071 255, wherein a semiconductor chip is mounted in a window of a multilayer arrangement. The chip is contacted through contacting areas with contact fingers which protrude into the window from a wiring pattern which is provided outside of the window on the top side of a plastic intermediate carrier.

In this conventional structure, on the upper surface of the wiring pattern, a metallic surface layer is provided in order to reduce the transition resistance between the wiring pattern on the one hand and the external contact areas on the other hand. These contact areas comprise a metallic basic material forming a thickening portion and a further metallic surface layer consisting of a material having a very low resistivity. For this purpose, the metallic basic material is applied by soldering, welding or bonding using the so-called reflow soldering method as explained in detail in EP-A-0 071 255, wherein a so-called self-alignment effect is used. However, this document does not disclose details how to make an IC card with an integrated printed wiring board or printed wiring pattern having external contact terminals of a required exactness and reliability.

Accordingly, the object underlying the present invention is to provide a method for preparing a printed wiring board for installation in an IC card in such a manner that the articles obtained thereby are of exact dimensions, have a high reliability and ensure a perfect electric contact in a reader/writer for IC cards.

In order to solve this problem, the method according to the invention comprises the following steps:
a) forming a plating mask on the printed wiring pattern and the substrate, the plating mask having windows, each window corresponding to the size and location of the respective contact terminals for forming bumps to be plated on a predetermined part of the printed wiring pattern;
b) plating an electroconductive material on the printed wiring pattern exposed by each of the windows of the plating mask to form platings having an exposed top surface;
c) keeping the plating mask in place over the printed wiring pattern at the substrate and surface treating the exposed top surface of the platings in order to make them bumps of exactly predetermined thickness;
d) removing the plating mask to expose the finished bumps; and
e) surrounding the bumps and covering the printed wiring pattern and the substrate with an over sheet of a non-conductive material.

According to a further development of the method according to the invention, the flat top surface of the platings to form the respective bumps is formed in such a manner that the flat top surface of each bump is coplanar with the flat upper surface of the over sheet of the IC card.

According to a further development of the method according to the invention, only the flat top surface, which is an external contact surface of the respective bump, is exposed on the surface of the IC card.

According to a further development of the method according to the invention, each bump formed on a conductor circuit of the printed wiring board forms an external contact terminal of the circuit contained in the IC card.

In one specific embodiment of the method according to the invention, a photosensitive resist film is used as the plating mask.

A plastic film with an adhesive is used as the plating mask in another specific embodiment of the method according to the invention.

According to a further development of the method according to the invention, the surface treatment is carried out by physical surface grinding.

In one specific embodiment of the method according to the invention, the physical surface grinding is made by sander-grinding.

The physical surface grinding is made by buff-grinding in another specific embodiment of the method according to the invention.

The invention will be described in more detail below with reference to preferred embodiments, examples and the accompanying drawings.

### Brief Description of the Drawings:

Figs. 1 and 2 are perspective views showing respective embodiments of printed wiring boards for installation in an IC card.

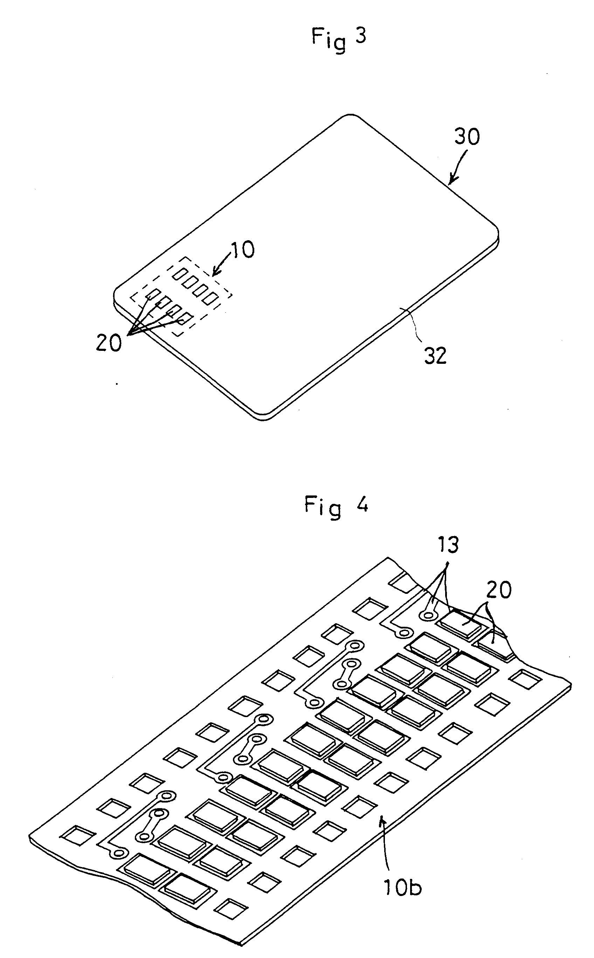

Fig. 3 is a perspective view of an IC card in which the printed wiring board shown in Fig. 1 or 2 is installed.

Fig. 4 is a partial perspective view showing a plurality of printed wiring boards for IC cards formed in a series as a long band.

Fig. 5 is a view showing an IC card formed with a printed wiring board in a partly magnified vertical sectional view wherein IC chips are built in.

Fig. 6 is a view corresponding to Fig. 5 and showing an IC card formed with a printed wiring board in a partly magnified vertical sectional view in a case where a printed wiring board with IC chips is installed.

Fig. 7 is a partly magnified vertical sectional view showing the vicinity of the respective external contact terminals shown in Figs. 5 and 6.

Figs. 8 to 11 are vertical sectional views showing the order steps of a method for preparing a printed wiring board for installation in an IC card according to the present invention.

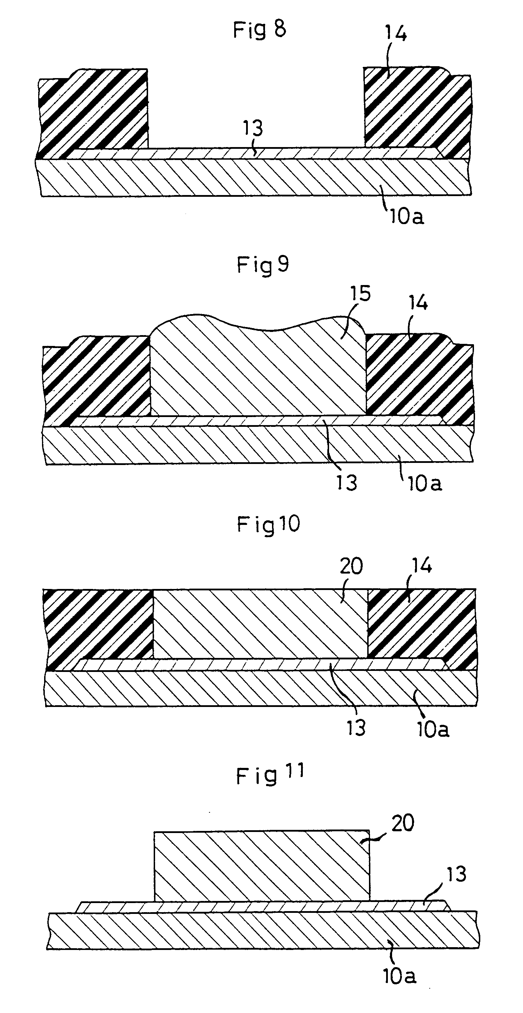

Fig. 8 is a partly magnified vertical sectional view showing how a plating mask is arranged for a conductor circuit for IC modules.

Fig. 9 is a partly magnified vertical sectional view showing how a predetermined plating to be formed in a bump is applied on the conductor circuit.

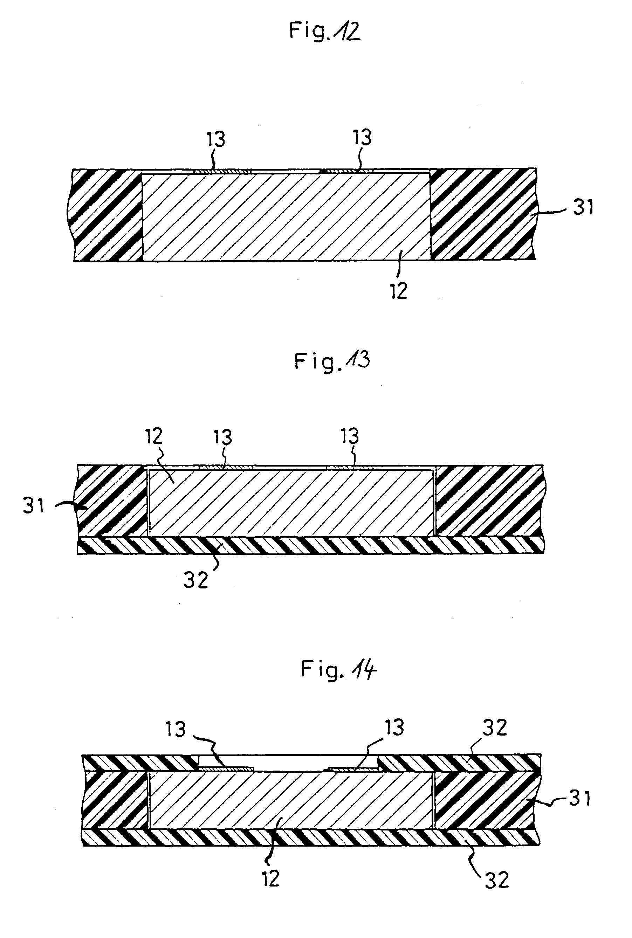

Fig. 10 is a partly magnified vertical sectional view showing that a plated part has been ground with the plating mask arranged as it is.

Fig. 11 is a partly magnified vertical sectional view showing that the plating mask has been removed to expose a bump.

Fig. 12 to 14 are partly magnified vertical sectional views showing conventional IC cards.

Fig. 12 is a partly magnified vertical sectional view showing that an IC module is arranged in a hole formed in a sheet-shaped card material.

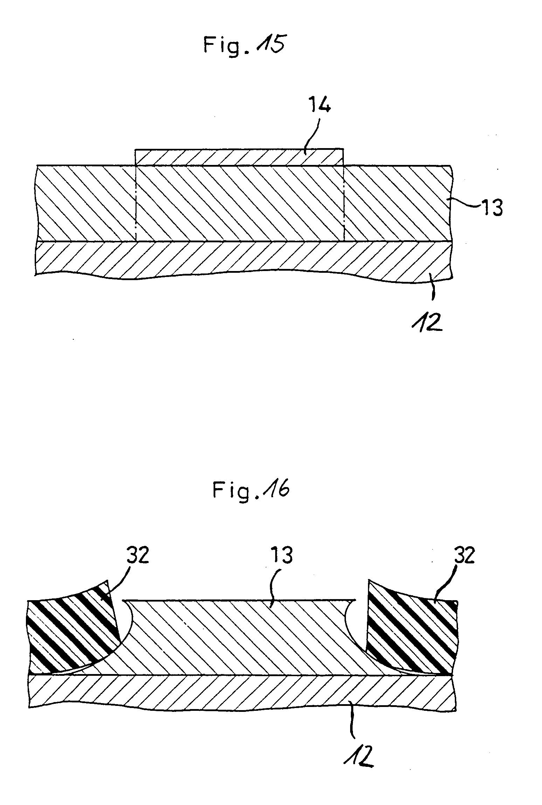

Fig. 13 is a partly magnified vertical sectional view showing that an over sheet is bonded to the lower side of the arrangement shown in Fig. 12.

Fig. 14 is a partly magnified vertical sectional view showing that an over sheet is also bonded to the upper side of the arrangement shown in Fig. 13.

Figs. 15 and 16 are respectively partly magnified vertical sectional views for explaining the problems in a case of forming an external contact terminal by an etching method.

### Explanation of Reference numerals

10...Printed wiring board for IC cards, 11...IC chip, 12...IC module, 13...Conductor circuit, 14...Plating mask, 15...Plating, 20...Bump, 21...Contact terminal part, 30...IC card, 31...Sheet-shaped card material. 32...Over sheet.

### Best Form for Embodying the Invention:

The present invention will be explained in detail in the following with reference to the respective embodiments shown in the drawings.

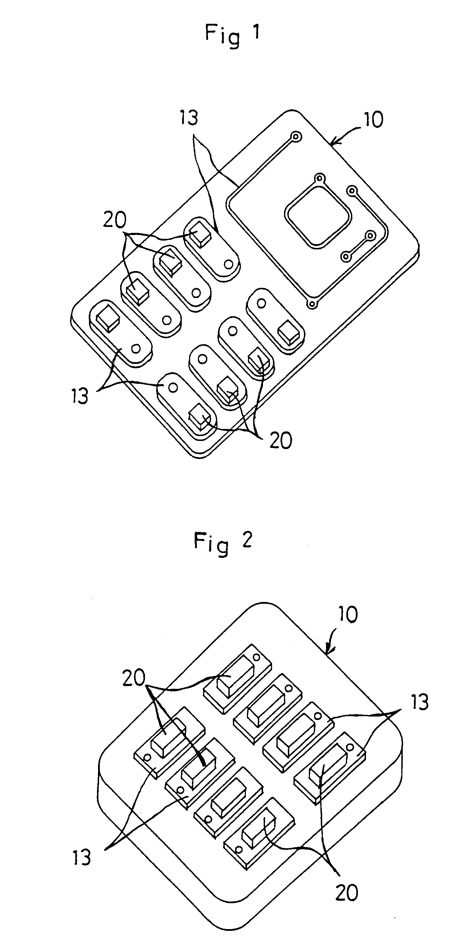

Figs. 1 and 2 are perspective views showing a printed wiring board 10 for IC cards prepared according to the present invention.

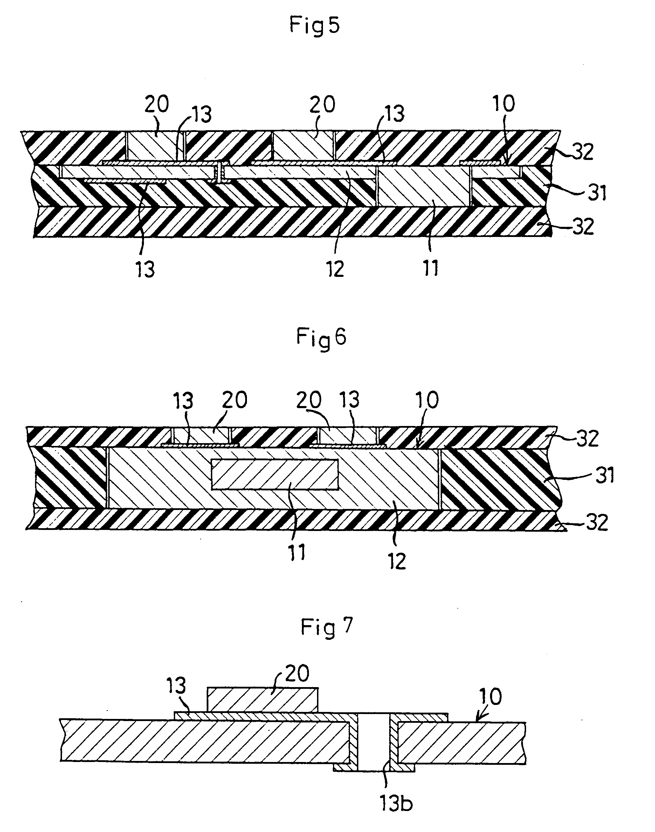

As shown in Fig. 5, the printed wiring board 10 for installation in IC cards shown in Fig. 1 is provided with electronic parts such as IC chips 11 so as to form an IC module 12.

In such a printed wiring board 10, bumps 20 of any thickness formed of an electroconductive material are provided on the surface of a part of a conductor circuit 13 formed on the surface of the IC module 12. In the printed wiring board 10 shown in Fig. 1, the IC module 12 is made by fitting an electronic part such as the IC chip 11 on the surface; therefore it can easily be made thin, a thicker over sheet 32 can be used in making an IC card 30 and therefore the reliability can be improved in case the IC card 30 is bent.

On the other hand, in the printed wiring board 10 shown in Fig. 2, as shown in Fig. 6, the IC module 12 is made by building therein an electronic part such as the IC chip 11. In such a printed wiring board 10, bumps 20 of any thickness formed of an electroconductive material are provided on the surface of a part of the conductor circuit 13 formed on the surface of the IC module 12. In the printed wiring board 10 shown in Fig. 2, the IC chip 11 is inserted into the printed wiring board 10, the back surface of the IC module 12 becomes flat. Therefore there is the advantage that, in case the IC card 30 is made by using such a printed wiring board 10, it will be easy to work the sheet-shaped card material 31 to make a card.

Here, the bumps 20 are parts projecting from a fixed surface and are of a material different from the material forming the surface.

Also, any thickness mentioned above means that the thickness of the bump 20 forming the external contact terminal when the IC module 12 is fitted to the IC card 30 is such that, as shown in Figs. 5 and 6, the surface of the bump 20 may be at least on the same plane level as the surface of the over sheet 32. According to the above mentioned bending standard test in the interim report "ISO/TC 97/SC 17 Identification and Credit Cards", June 1984, the thickness of the bump 20 which forms the external contact terminal is required to be at least 0,1 mm.

The thickness of the bump 20 is such that the surface of the bump 20 may be at least on the same plane level as the surface of the over sheet 32. Therefore, in order that the bump 20 may electrically contact a reader/writer for IC cards, the surface of the bump 20 is required to be flush with or project from the surface of the over sheet 32 or to be preferably the same as that of the over sheet 32.

The bump 20 may be formed of such electroconductive material as, for example, preferably copper or nickel or alloys thereof. Further, in order to ensure the conductivity and abrasion-resistance of the bump 20, it is preferable to form the contact surface of the bump of gold, platinum, silver, palladium, iridium, osmium, tungsten, copper, chromium, nickel or carbon or its alloys.

By the formation as explained above, with the bump 20 having a flat contact surface and a thickness of about 0,1 to 0,3 mm, when the printed wiring board 10 which is to form the IC module 12 is fitted to the IC card 20, the surface of the bump 20 forming the external contact terminal will be flush with the surface of the over sheet 32 and only the contact surface of the bump 20 will be exposed on the surface of the IC card 30.

Further, in the printed wiring board 10, in particular as shown in Fig. 7, the bump 20 is formed separately from the conductor circuit 13 formed on the surface of the IC module 12. In other words, the bump 20 is formed on the conductor circuit 13 of the printed wiring board 10 for IC cards and on the surface of the part corresponding to the external contact terminal. Therefore, not only such a through hole 13b as is shown in Fig. 7 can be formed in the part of the conductor circuit 13 laminated with the over sheet 32, but also the thickness of the conductor circuit 13 can thereby be made as thin as possible. So, in case the conductor circuit 13 is laminated with the over sheet 32, even if the over sheet 32 is thick, the limitation of the thickness of an IC card of this kind will be less.

The method for preparing a printed wiring board 10 for installation in an IC card according to the present invention will be explained in the following.

The method of forming the bumps 20 by plating is as shown in Figs. 8 to 11. First of all, a plating mask 14 having windows each of which is corresponding to the size of the required bump 20 is formed in advance and is pasted to the required part of the conductor circuit 13 as shown in Fig. 8. As shown in Fig. 9, a plating 15 can be formed by applying a non-electrolytic or an electrolytic plating to the conductor circuit 13 exposed through each window of the plating mask 14. The plating mask 14 used here is made of a plastic film such as polyester, vinyl chloride or polypropylene with an adhesive , and is made to correspond to predetermined positions of the conductor circuit 13 in which the bumps 20 forming the external contact terminals are to be provided and is punched only in the external contact terminal parts with a die or the like to form the respective windows. Alternatively, a photosensitive resist film or ink used to provide ordinary printed wiring boards is formed with a required thickness for the plating mask 14 and is used as adapted to a plating bath.

As a plating method, in case the bump 20 has to be comparatively thin, a non-electrolytic plating will be preferable and, in case the bump 20 has to be thick, an electrolytic plating will be preferable. As the kind of the plating metal, copper or nickel is preferable. In particular, the electrolytic plating method wherein a plating solution is jetted onto a part to be partly plated, while a predetermined part of the plating mask 14 is covered with an automatically mechanically fitted elastic film such as rubber is so effective that a required plating thickness can be obtained within a short time and the variation of the thickness is little.

When the thus formed plating 15 is treated on the surface, it is for sure that the contact surface of the bump 20 formed of this plating 15 will be plane. The surface treating methods in this connection include chemical polishing, electrolytic polishing, and physical grinding.

In particular, as shown in Fig. 10, when the plating 15 obtained as described above is physically surface-ground with a buff, sander or the like only on the upper surface while the plating mask 14 is formed as it is, the smoothness of the plating mask 14 itself can be utilized, the variation of the plating thickness can be eliminated and the grinding flaws can be eliminated. By taking such method, bumps 20 which are very smooth on the plated surface, high in the plane precision and very high in the position precision can be obtained.

Thereafter, the plating mask 14 is removed so as to expose the bump 20 as shown in Fig. 11. Finally, an oversheet of a non-conductive material will be applied as shown in Fig. 5 and Fig. 6 surrounding the respective bumps 20 and covering the printed wiring pattern.

### Example 1:

This example is to form bumps 20 by plating.

A glass epoxy copper foil laminate (copper thickness of 18 µm on both surfaces) was provided with holes with an NC drill and then a required wiring pattern (conductor circuit 13) was formed of the laminate by an ordinary subtractive method. In order to form the bumps 20 by the electrolytic plating after the pattern was formed, four sheets of Laminar TA 50,8 µm (2 mil) thick produced by Dynachem Co. were overlapped and laminated as a plating mask 14. Then, by using the mask required to form the bumps 20, the pattern was exposed with 300 mJ/cm². with a 201B type exposing machine manufactured by Oak Co. and was then developed by using an aqueous solution of 2 % sodium carbonate. Then, the plated part of the contact terminal part was exposed, was pre-treated as required for plating and was plated for about 3,5 hours with a current density of 4A /dm². by using a copper sulfate plating solution to form a plating 15.

This plating 15 was set in the thickness with a belt sander (manufactured by Kikukawa Iron Works Co.,Sander No. 600) and was wet-ground. Then, the plating mask 14 was removed with methylene chloride. Further, the conductor circuit 13 and the bump 20 were respectively nickel-plated and gold-plated to thereby form the bump 20 thicker by 150 ± 20 µm than the conductor of the conductor circuit 13, having an area of (2,5 ± 0,025) mm. x (1,9 ± 0,025) mm and being smooth on the surface. The printed wiring board 10 for IC cards having the bumps 20 were as shown in Fig. 2.

When a vinyl chloride sheet (over sheet 32) of a thickness of 76,2 µm (3 mil) provided with windows punched with a die in the positions corresponding to the respective bumps 20 of the printed wiring board 10 for IC cards was overlapped on the printed wiring board 10 and was heat-pressed for 2 minutes at a temperature of 95°C., they could be joined so that there was no gap between the over sheet 32 and bump 20, and the surfaces of the over sheet 32 and bump 20 were on the same plane level, as shown in Fig. 5 and Fig. 6.

### Example 2:

This example is to form bumps 20 by plating.

A printed wiring pattern was formed as in the above mentioned Example 1 and a polyester film of a thickness of 200 µm fitted with an adhesive on one surface was punched with a die to form holes corresponding to the size of the bumps 20. Then, this film was positioned on a printed wiring board 10a and was bonded under pressure. The printed wiring board 10a was electrolytically plated with a thickness of 180 µm by using an electrolytic Ni plating solution (sulfamic acid bath) to form a plating 15. At this time, the current density was 10 A /dm². and the time was 100 minutes.

This plating 15 was wet-ground with Tsunoda Brush P No. 600. When the above mentioned polyester film was peeled off and the thickness of the bump 20 was measured, there had been obtained the bump 20 thicker by 130 ± 20 µm than the other conductor wiring and having a smooth plane.

The printed wiring board obtained with the method according to the invention can be used for installation in various IC cards, including cash card, credit cards, identification cards, medical cards and telephone cards.

## Claims

1. A method for preparing a printed wiring board for installation in an IC card, wherein the printed wiring board comprises a substrate (10, 10a) of a non-conductive material, a printed wiring pattern (13) on the substrate (10, 10a), and external contact terminals on the printed wiring pattern (13), adapted for operation in a reader/writer of IC cards, comprising the following steps:
a) forming a plating mask (14) on the printed wiring pattern (13) and the substrate (10, 10a), the plating mask (14) having windows, each window corresponding to the size and location of the respective contact terminals for forming bumps (20) to be plated on a predetermined part of the printed wiring pattern (13);
b) plating an electroconductive material on the printed wiring pattern (13) exposed by each of the windows of the plating mask (14) to form platings (15) having an exposed top surface;
c) keeping the plating mask (14) in place over the printed wiring pattern (13) at the substrate (10,10a),and surface treating the exposed top surface of the platings (15) in order to make them bumps (20) of exactly predetermined thickness;
d) removing the plating mask (14) to expose the finished bumps (20); and
e) surrounding the bumps (20) and covering the printed wiring pattern (13) and the substrate (10, 10a) with an over sheet (32) of a non-conductive material.

2. The method according to claim 1,
wherein the flat top surface of the platings (15) to form the respective bumps (20) is formed in such a manner that the flat top surface of each bump (20) is coplanar with the flat upper surface of the over sheet (32) of the IC card.

3. The method according to claim 1 or 2,
wherein only the flat top surface, which is an external contact surface of the respective bump (20), is exposed on the surface of the IC card.

4. The method according to any of claims 1 to 3,
wherein each bump (20) formed on a conductor circuit (13) of the printed wiring board forms an external contact terminal of the circuit contained in the IC card.

5. The method according to any of claims 1 to 4,
wherein a photosensitive resist film is used as the plating mask (14).

6. The method according to any of claims 1 to 4,
wherein a plastic film with an adhesive is used as the plating mask (14).

7. The method according to any of claims 1 to 6,
wherein the surface treatment is carried out by physical surface grinding.

8. The method according to claim 7,
wherein the physical surface grinding is made by sander-grinding.

9. The method according to claim 7,
wherein the physical surface grinding is made by buff-grinding.

## Patentansprüche

1. Verfahren zum Herstellen einer gedruckten Leiterplatte zum Einbau in eine IC-Karte, wobei die Leiterplatte folgendes aufweist: ein Substrat (10, 10a) aus einem nichtleitfähigen Material, ein gedrucktes Leitungsmuster (13) auf dem Substrat (10, 10a) und äußere Kontaktanschlüsse auf dem gedruckten Leitungsmuster (13), ausgelegt zum Betrieb in einem Schreib/Lesegerät für IC-Karten,
wobei das Verfahren folgende Schritte aufweist:
a) Bilden einer Plattiermaske (14) auf dem gedruckten Leitungsmuster (13) und dem Substrat (10, 10a), wobei die Plattiermaske (14) Fenster hat und jedes Fenster der Größe und Lage der jeweiligen Kontaktanschlüsse entspricht, um Kontakthöcker (20) zu bilden, die auf einen vorbestimmten Teil des gedruckten Leitungsmusters (13) zu plattieren sind;
b) Plattieren eines elektrisch leitfähigen Materials auf das gedruckte Leitungsmuster (13), das durch jedes der Fenster der Plattiermaske (14) freiliegt, um Plattierungen (15) mit einer freiliegenden oberen Oberfläche zu bilden;
c) Halten der Plattiermaske (14) in ihrer Lage über dem gedruckten Leitungsmuster (13) auf dem Substrat (10, 10a) und Oberflächenbehandeln der freiliegenden Oberfläche der Plattierungen (15), um aus ihnen Kontakthöcker (20) genau vorbestimmter Dicke zu machen;
d) Entfernen der Plattiermaske (14), um die fertigen Kontakthöcker (20) freizulegen; und
e) Umgeben der Kontakthöcker (20) und Abdecken des gedruckten Leitungsmusters (13) und des Substrats (10, 10a) mit einem darüberliegenden Flächenkörper (32) aus einem nichtleitfähigen Material.

2. Verfahren nach Anspruch 1,
wobei die flache Oberfläche der Plattierungen (15) zum Bilden der jeweiligen Kontakthöcker (20) auf eine solche Weise gebildet wird, daß die flache Oberfläche jedes Kontakthöckers (20) mit der flachen Oberfläche des darüberliegenden Flächenkörpers (32) der IC-Karte koplanar ist.

3. Verfahren nach Anspruch 1 oder 2,
wobei nur die flache Oberfläche, die eine äußere Kontaktfläche des jeweiligen Kontakthöckers (20) ist, an der Oberfläche der IC-Karte freiliegt.

4. Verfahren nach einem der Ansprüche 1 bis 3, wobei jeder Kontakthöcker (20), der auf einem Leiterkreis (13) der gedruckten Leiterplatte gebildet ist,
einen äußeren Kontaktanschluß des in der IC-Karte enthaltenen Schaltkreises bildet.

5. Verfahren nach einem der Ansprüche 1 bis 4,
wobei eine lichtempfindliche Resistschicht als Plattiermaske (14) verwendet wird.

6. Verfahren nach einem der Ansprüche 1 bis 4,
wobei eine Kunststoffschicht mit einem Klebstoff als Plattiermaske (14) verwendet wird.

7. Verfahren nach einem der Ansprüche 1 bis 6,
wobei die Oberflächenbehandlung durch körperliches Planschleifen durchgeführt wird.

8. Verfahren nach Anspruch 7,
wobei das körperliche Planschleifen durch Sandschleifen erfolgt.

9. Verfahren nach Anspruch 7,
wobei das körperliche Planschleifen durch Schwabbeln erfolgt.

## Revendications

1. Un procédé de fabrication d'une plaquette à câblage imprimé pour cartes à circuits intégrés, dans lequel la plaquette à câblage imprimé comprend un substrat (10, 10a) en matière non conductrice, une configuration de câblage imprimé (13) sur le substrat (10, 10a) et des bornes de contact extérieures sur la configuration de câblage imprimé (13), adaptés pour être utilisés dans un lecteur/enregistreur de cartes à circuits intégrés,
comprenant les phases suivantes :
a) formage d'un masque de placage (14) sur la configuration de câblage imprimé (13) et le substrat (10, 10a), le masque de placage (14) ayant des fenêtres, chaque fenêtre correspondant à la taille et à l'emplacement des différentes bornes de contact pour former des bosses (20) à plaquer sur une partie prédéterminée de la configuration de câblage imprimée (13) ;
b) placage d'une matière électroconductrice sur la configuration de câblage imprimé (13) exposée par chacune des fenêtres du masque de placage (14) pour former des placages (15) ayant une surface supérieure exposée ;
c) maintien du masque de placage (14) en place sur la configuration de câblage imprimé (13) au substrat (10, 10a) et traitement de surface de la surface supérieure exposée des placages (15) afin d'en faire des bosses (20) d'une épaisseur prédéterminée avec exactitude ;
d) enlèvement du masque de placage (14) pour exposer les bosses finales (20) ; et
e) entourage des bosses (20) et application sur la configuration de câblage imprimé (13) et le substrat (10, 10a) d'une feuille de recouvrement (32) en matière non conductrice.

2. Le procédé selon la revendication 1,
dans lequel la surface supérieure plate des placages (15) pour former les différentes bosses (20) est formée de telle sorte que la surface supérieure plate de chaque bosse (20) soit coplanaire avec la surface supérieure plate de la feuille de recouvrement (32) de la carte à circuits intégrés.

3. Le procédé selon la revendication 1 ou 2,
dans lequel la surface supérieure plate, qui est une surface de contact extérieure de la bosse correspondante (10), est exposée sur la surface de la carte à circuits intégrés.

4. Le procédé selon l'une des revendications 1 à 3,
dans lequel chaque bosse (20) formée sur un circuit conducteur (13) de la plaquette à câblage imprimé forme une borne de contact extérieure du circuit contenu dans le carte à circuits intégrés.

5. Le procédé selon l'une des revendications 1 à 4,
dans lequel un film photoresist est utilisé comme masque de placage (14).

6. Le Procédé selon l'une des revendications 1 à 4,
dans lequel un film plastique avec une colle est utilisé comme masque de placage (14).

7. Le Procédé selon l'une des revendications 1 à 6,
dans lequel le traitement de surface est réalisé par rectification de surface physique.

8. Le procédé selon la revendication 7,
dans lequel la rectification de surface physique est réalisé par ponçage.

9. Le procédé selon la revendication 7,
dans lequel la rectification de surface physique est réalisé par polissage.
